# EUROPEAN PATENT SPECIFICATION

(11) **EP 3 879 276 B1**
(45) Date of publication and mention of the grant of the patent: **22.04.2026**
(21) Application number: 19909532.4
(22) Date of filing: 19.12.2019
(51) Int. Cl.: G01R 1/20

(54) **SHUNT SENSOR**
SHUNT-SENSOR
CAPTEUR DE DÉRIVATION

(30) Priority: 10.01.2019 JP 2019002302
(43) Date of publication of application: 15.09.2021
(73) Proprietor: Suncall Corporation, Kyoto-shi, Kyoto 615-8555 (JP)
(72) Inventor: MURAKAMI, Kenji, Kyoto-shi, Kyoto 615-8555 (JP); MUGISHIMA Akio, Kyoto-shi, Kyoto 615-8555 (JP)
(74) Representative: Hoffmann Eitle
(86) International application number: PCT/JP2019/049724
(87) International publication number: WO 2020/145065

(56) References cited:
- DE-A1- 102004 042 719
- DE-A1- 102014 207 759
- JP-A- 2000 131 350
- JP-A- 2009 236 641
- JP-A- 2013 124 859
- JP-A- 2014 137 223
- JP-A- 2015 021 816
- JP-A- 2015 021 816
- JP-A- 2017 011 087
- JP-A- 2017 015 588
- JP-A- 2017 211 294
- KR-B1- 101 374 381
- US-A1- 2016 141 731
- US-A1- 2018 172 735

## Description

### Technical Field

The present invention relates to a shunt sensor in which a substrate on which a current detection circuit is mounted is fixed to a shunt resistor, and in particular, to a shunt sensor used in measuring a current value of a current path through which a large current flows from a battery for high-voltage applications to a motor circuit that are used in, for example, electric vehicles (EVs), hybrid vehicles (HVs), and plug-in hybrid vehicles (PHVs).

### Background Art

A shunt sensor as described in JP 2015-145803 is known as a conventional shunt sensor. This shunt sensor is such that a substrate on which a current detection circuit is mounted is arranged and screw-fixed on an electrode of a shunt resistor having a resistor and a pair of electrodes.

JP 2015-021816 discloses a shunt resistive current sensor comprising a bus bar which includes a shunt resistor part. Two individual voltage sensing terminals and a ground terminal include a base portion and a tip. A printed circuit board receives the tips of the terminals. US 2018/172735 discloses a current sensing device including a resistive element and two electrodes including respective voltage sensing terminals. In the embodiment depicted in Fig. 17C, the terminals include a terminal portion and a flange. US 2016/141731 discloses a battery state detection device including a shunt resistor formed by a resistor element and two conductor parts. The conductor parts have connecting parts.

### Summary of the Invention

### Technical Problem

However, the shunt sensor as described above has a problem that heat dissipation measures are insufficient because the substrate is screw-fixed even though it is arranged on the resistor that generates the most heat and its peripheral part. Particularly, the heat dissipation measures become more problematic when the shunt sensor is used in applications where a large current flows.

Further, there is a problem in screw fixing that the number of parts is increased in addition to very complicated work man-hours at the time of mounting work of thousands of pieces per month to tens of thousands of pieces per month.

Accordingly, in view of the foregoing problems, an object of the present invention is to provide a shunt sensor capable of improving the heat dissipation measures and reducing the number of parts.

### Solution to the Problems

The above object of the present invention is achieved by the following means. It is noted that numerals in parentheses are reference numerals of embodiments to be described later, but the present invention should not be restricted thereto.

According to the first aspect of the present invention, a shunt sensor according to claim 1 is provided.

On the other hand, according to the second aspect of the present invention, a shunt sensor according to claim 2 is provided.

According to the third aspect of the present invention, a shunt current sensor according to claim 3 is provided.

Further, according to the fourth aspect of the present invention, the shunt sensor according to the above second aspect is characterized in that one of the fixing terminals (4A, 4B) fixed to the substrate (3A, 3B) is connected to a ground pattern formed on the substrate (3A, 3B).

### Advantageous Effects of the Invention

Next, advantageous effects of the present invention will be described with reference signs in the drawings. It is noted that signs in parentheses are reference signs of an embodiment to be described later, but the present invention should not be limited thereto.

According to the first aspect of the present invention, when the substrate (3, 3A) is arranged at the position opposed to the base members (21), the substrate (3, 3A) is placed on the flange parts (22b). Thus, a gap (S1) is formed between the base members (21) and the substrate (3, 3A), and heat generated in the resistor (20) and its periphery is dissipated by the gap (S1).

Thus, according to the present invention, the heat dissipation measures can be improved.

Further, according to the present invention, when the substrate (3, 3A) is arranged at the position opposed to the base members (21), the substrate (3, 3A) is fixed only by welding (32) instead of being screw-fixed as in the conventional case. Thus, the number of parts can be reduced.

On the other hand, according to the second aspect of the present invention, when the substrate (3, 3B) is arranged at the position opposed to the base members (21), the substrate (3, 3B) is placed on the protruding parts (21b). Thus, a gap (S1) is formed between the base members (21) and the substrate (3, 3B), and heat generated in the resistor (20) and its periphery is dissipated by the gap (S1).

Thus, according to the present invention, the heat dissipation measures can be improved.

Further, according to the present invention, when the substrate (3, 3B) is arranged at the position opposed to the base members (21), the substrate (3, 3B) is fixed only by welding (32, 32B) instead of being screw-fixed as in the conventional case. Thus, the number of parts can be reduced.

On the other hand, according to the third aspect of the present invention, when the substrate (3A, 3B) is arranged and fixed at the position opposed to the base members (21), at least one fixing terminal (4A, 4B) is fixed to the substrate (3A, 3B). Thus, the substrate (3A, 3B) can be firmly arranged and fixed at the position opposed to the base members (21).

Further, according to the fourth aspect of the present invention, one of the fixing terminals (4A, 4B) fixed to the substrate (3A, 3B) is connected to a ground pattern formed on the substrate (3A, 3B), therefore, anti-noise measures can be taken and the current value of the current path through which a large current flows from the battery for high-voltage applications to the motor circuit can be measured with high accuracy.

### Brief Description of the Drawings

FIG. 1 is a perspective view of a shunt sensor according to an embodiment of the present invention.
FIG. 2 is a partial half sectional view of the shunt sensor according to the same embodiment.
FIG. 3 is a partial half sectional view of a shunt sensor according to another embodiment.
FIG. 4 is a partial half sectional view of a shunt sensor according to still another embodiment.

### Description of the Embodiments

Hereinafter, one embodiment of a shunt sensor according to the present invention will be specifically described with reference to the drawings. It is noted that, in the following description, up/down and left/right directions shall be referred to as up/down and left/right directions when viewed from the front of the figure.

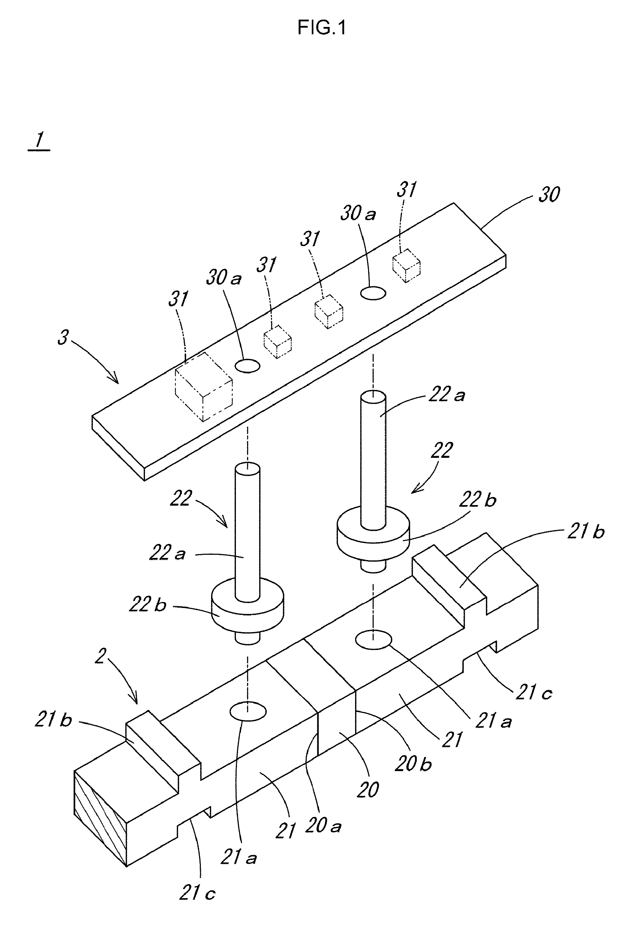

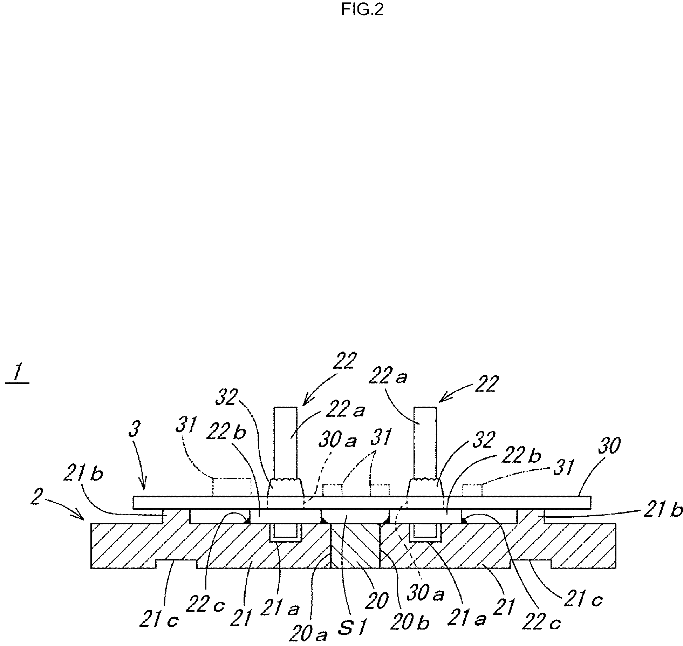

The shunt sensor according to the present embodiment is particularly used in measuring a current value of a current path through which a large current flows from a battery for high-voltage applications to a motor circuit that are used in, for example, electric vehicles (EVs), hybrid vehicles (HVs), and plug-in hybrid vehicles (PHVs). As shown in Fig. 1 and Fig. 2, a shunt sensor 1 is composed of a shunt resistor 2 and a substrate 3.

The shunt resistor 2 is composed of a resistor 20, a pair of base members 21 integrally formed with the resistor 20 so as to sandwich the resistor 20, and a measurement terminal 22 erected and fixed by welding on each of the pair of the base members 21. As shown in Fig. 1 and FIG. 2, the resistor 20 is formed in, for example, a thick plate-like short rectangular shape having a thickness of about 3 mm to 5 mm, and preferably formed of, for example, Cu-Mn alloys, Cu-Ni alloys, or Ni-Cr alloys, and is a resistor on the order of 50 µΩ to 200 µΩ. On both side surfaces 20a, 20b of the resistor 20 thus formed, the base member 21 located on the left in the figure is joined by welding to one of the side surfaces 20a of the resistor 20, and the base member 21 located on the right in the figure is joined by welding to the other side surface 20b of the resistor 20 as shown in Fig. 1 and FIG. 2. As a result, the pair of base members 21 are integrally formed with the resistor 20 so as to sandwich the resistor 20.

On the other hand, the base member 21 is a so-called bus bar, formed of metal such as copper, and as shown in FIG. 1 and FIG. 2, formed in, for example, a thick plate-like long rectangular shape having a thickness of about 3 mm to 5 mm. The base member 21 has its upper surface formed with a circular recessed hole 21a having, for example, a diameter of about 1.5 mm to 2 mm and a depth of about 1 mm to 1.5 mm in the vicinity of each side surface 20a, 20b of the resistor 20, as shown in FIG. 1 and FIG. 2. Further, on the upper surface of the base member 21, as shown in FIG. 1 and FIG. 2, a thick plate-like rectangular protruding part 21b is integrally formed in a direction orthogonal to the longitudinal direction of the base member 21 at a position spaced apart at a predetermined distance from the recessed hole 21a in a direction opposite to each side surface 20a, 20b of the resistor 20. Further, as shown in FIG. 1 and FIG. 2, the base member 21 has its lower surface formed with a recessed part 21c at a position opposite to the position where the protruding part 21b is formed. The protruding part 21b and the recessed part 21c are formed by, for example, dowel processing.

On the other hand, the measurement terminal 22 is capable of mounting thereon a substrate 3 for current detection, and formed of, for example, copper or tin plating, and as shown in FIG. 1 and FIG. 2, integrally formed of a rod-like shaft part 22a and a circular flange part 22b located on the lower side of the shaft part 22a and provided in a circumferentially and outwardly protruding manner. The shaft part 22a is a current measurement terminal used in measuring the current value, is formed to have a diameter of, for example, about 1 mm to 1.5 mm, and is formed smaller than the diameter of the recessed hole 21a. As a result, as shown in FIG. 2, the shaft part 22a can be inserted into the recessed hole 21a.

On the other hand, the diameter of the flange part 22b is formed at, for example, about 2.5 mm to 3 mm, and is formed slightly larger than that of the recessed hole 21a. As a result, as shown in FIG. 2, only the shaft part 22a is inserted into the recessed hole 21a, and the flange part 22b is placed on the upper surface of the base member 21. When, in this state, as shown in FIG. 2, a side circumferential surface of the flange part 22b is welded 22c by, for example, resistance welding, the measurement terminal 22 is erected and fixed on the base member 21. The thickness of the flange part 22b is almost the same as that of the protruding part 21b.

As shown in FIG. 1, the substrate 3 is formed in a horizontally long rectangular shape and includes a substrate main body 30 formed of, for example, a resin. As shown in FIG. 1 and FIG. 2, various IC chips 31 constituting a current detection circuit are mounted on the substrate main body 30 and are electrically connected by a wiring pattern (not shown). Further, the substrate main body 30 is provided with a through hole 30a into which the shaft part 22a of the measurement terminal 22 can be inserted, as shown in FIG. 1. The through hole 30a is provided in a vertically and circularly penetrating manner, is formed to have a diameter of about 1.5 mm to 2 mm, is formed slightly larger than the diameter of the shaft part 22a, and is formed slightly smaller than the diameter of the flange part 22b. As a result, as shown in FIG. 2, only the shaft part 22a of the measurement terminal 22 is inserted into the through hole 30a, and the lower surface of the substrate main body 30 is placed on the flange part 22b of the measurement terminal 22, and further, the lower surface of the substrate main body 30 is placed on the protruding part 21b. When, in this state, as shown in FIG. 2, a side circumferential surface of the shaft part 22a located on the upper surface side of the substrate main body 30 is welded 32 by, for example, resistance welding, the substrate 3 is arranged and fixed at the position opposed to the base member 21.

Thus, when the substrate 3 is arranged and fixed at the position opposed to the base member 21 in this manner, the current value generated by the current to be detected flowing through the resistor 20 from the base member 21 is taken out from the measurement terminal 22, subjected to signal processing by various IC chips 31 constituting the current detection circuit, and output from an output terminal (not shown) of the substrate 3 as a detection current. As a result, the current value of the current path through which a large current flows from the battery for high-voltage applications to the motor circuit can be measured. Although not shown, a power supply pattern and a ground pattern are formed on the substrate main body 30.

Thus, according to the present embodiment described above, when the substrate 3 is arranged and fixed at the position opposed to the base member 21, the lower surface of the substrate main body 30 is placed on the flange part 22b of the measurement terminal 22 and also placed on the protruding part 21b. As a result, as shown in FIG. 2, a gap S1 is formed between the base member 21 and the substrate 3, and then the heat generated in the resistor 20 and its periphery is dissipated by the gap S1.

Thus, according to the present embodiment, the heat dissipation measures can be improved.

Further, according to the present embodiment, when arranged and fixed at the position opposed to the base member 21, the substrate 3 is fixed only by welding 32 by, for example, resistance welding, instead of being screw-fixed as in the conventional case. The number of parts can therefore be reduced.

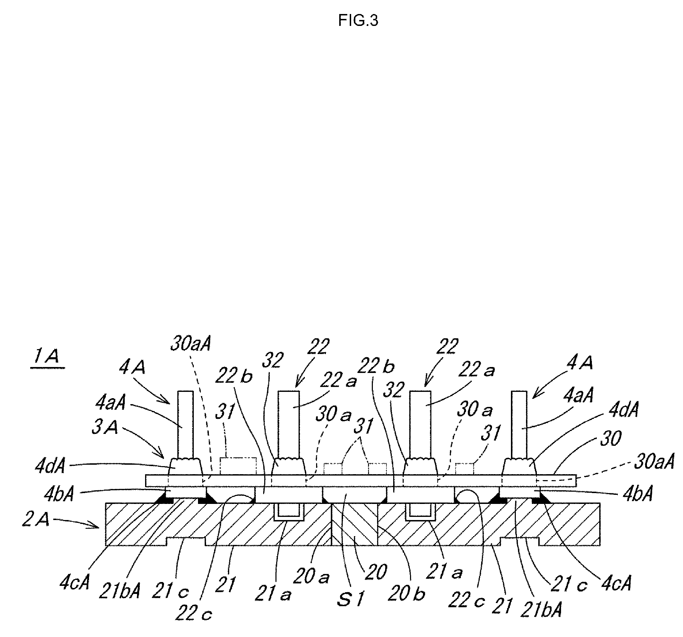

It is noted that the shunt sensor 1 shown in the present embodiment is merely an example, and various modifications and changes can be made within the scope of the present invention as defined by the claims. For example, when arranged and fixed at the position opposed to the base member 21, the substrate 3 may be fixed using a fixing terminal in order to be fixed more firmly. This point will be specifically described with reference to FIG. 3. The same configurations as those of the shunt sensor 1 shown in FIG. 1 and FIG. 2 are denoted by the same reference signs, and their detailed description will be omitted.

A shunt sensor 1A shown in FIG. 3 is composed of a shunt resistor 2A, a substrate 3A, and fixing terminals 4A. The difference between the shunt resistor 2A shown in FIG. 3 and the shunt resistor 2 shown in FIG. 1 and FIG. 2 is that the thickness of a protruding part 21bA formed on the upper surface of the base member 21 shown in FIG. 3 is smaller than that of the protruding part 21b formed on the upper surface of the base member 21 shown in FIG. 1 and FIG. 2, and other aspects are the same. As a result, the thickness of the protruding part 21bA is smaller than that of the flange part 22b.

On the other hand, the difference between the substrate 3A shown in FIG. 3 and the substrate 3 shown in FIG. 1 and FIG. 2 is that a fixing terminal through hole 30aA into which the fixing terminal 4A can be inserted is newly provided, and other aspects are the same. The fixing terminal through hole 30aA is provided in each side end face side of the substrate main body 30 and provided in a vertically and circularly penetrating manner.

As shown in FIG. 3, the fixing terminal 4A is integrally formed of a rod-like shaft part 4aA and a circular flange part 4bA located at a lower end of the shaft part 4aA and is provided in a circumferentially and outwardly protruding manner. As shown in FIG. 3, the shaft part 4aA is inserted into the fixing terminal through hole 30aA provided in the substrate 3A and is formed to have a diameter slightly smaller than that of the fixing terminal through hole 30aA.

On the other hand, the flange part 4bA is placed on the protruding part 21bA formed on the upper surface of the base member 21 and is formed to have a diameter slightly larger than that of the fixing terminal through hole 30aA. As a result, as shown in FIG. 3, only the shaft part 4aA is inserted into the fixing terminal through hole 30aA, the flange part 4bA is placed on the protruding part 21bA, and the lower surface of the substrate main body 30 is placed on the flange part 4bA. When, in this state, as shown in FIG. 3, a side circumferential surface of the flange part 4bA is welded 4cA by, for example, resistance welding, the fixing terminal 4A is erected and fixed on the protruding part 21bA formed on the upper surface of the base member 21. Further, when a side circumferential surface of the shaft part 4aA located on the upper surface side of the substrate main body 30 is welded 4dA by, for example, resistance welding, the substrate 3A is more firmly fixed at the position opposed to the base member 21. The thickness of the flange part 4bA is almost the same as that of the flange part 22b when combined with the thickness of the protruding part 21bA such that the lower surface of the substrate main body 30 is placed on the flange part 4bA.

Thus, in this way as well, as shown in FIG. 3, a gap S1 is formed between the base member 21 and the substrate 3A, and the heat generated in the resistor 20 and its periphery is dissipated by the gap S1.

Thus, in the present embodiment as well, the heat dissipation measures can be improved.

Further, all parts are fixed only by welding, instead of being screw-fixed as in the conventional case, the number of parts can therefore be reduced.

Meanwhile, either one of the two exemplified as the fixing terminal 4A shown in FIG. 3 is connected to a ground pattern (not shown) formed on the substrate main body 30. As a result, anti-noise measures can be taken and the current value of the current path through which a large current flows from the battery for high-voltage applications to the motor circuit can be measured with high accuracy.

Here, due to the following reason, only either one of the two exemplified as the fixing terminal 4A shown in FIG. 3 is connected to the ground pattern (not shown) formed on the substrate main body 30, instead of connecting both of them. That is, if both exemplified as the fixing terminal 4A shown in FIG. 3 are connected to the ground pattern (not shown) formed on the substrate main body 30, the two fixing terminals 4A are electrically connected. As a result, the current generated by the current to be detected flowing through the resistor 20 from the base member 21 may flow into the ground pattern (not shown) formed on the substrate main body 30. If the current flows into the ground pattern (not shown) in this way, the flown-current may also be added and an erroneous current value may be taken out from the measurement terminal 22, and therefore a measurement error may occur. Therefore, in the present embodiment, in order to reduce the possibility of causing such a measurement error, only either one of the two exemplified as the fixing terminal 4A shown in FIG. 3 is connected to the ground pattern (not shown) formed on the substrate main body 30, instead of connecting both of them.

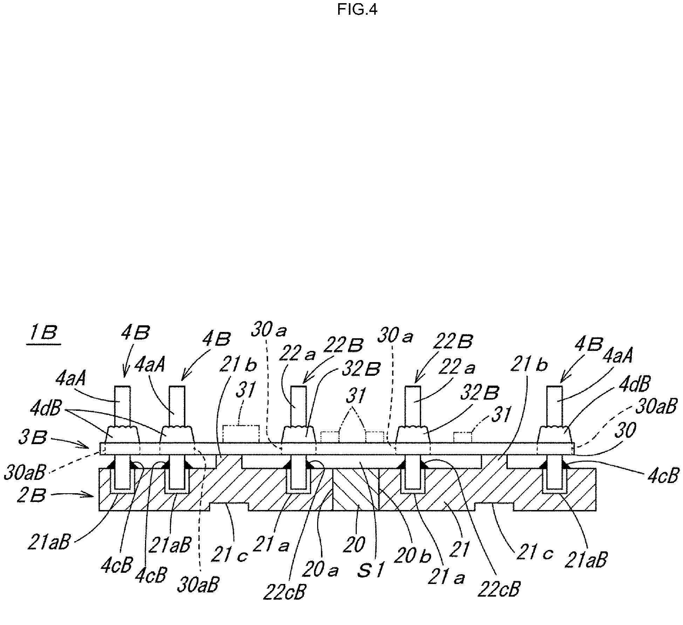

Further, although an example in which two fixing terminals 4A are used is shown in FIG. 3, one fixing terminal 4A may be used or three or more fixing terminals 4A may be used. Further, in forming the gap S1, although an example in which the protruding part 21b formed on the upper surface of the base member 21 and the flange part 22b of the measurement terminal 22 are formed is shown in the shunt sensor 1 shown in FIG. 1 and FIG. 2, and an example in which the protruding part 21bA formed on the upper surface of the base member 21, the flange part 22b of the measurement terminal 22, and the flange part 4bA of the fixing terminal 4bA are formed is shown in the shunt sensor 1A shown in FIG. 3. However, only either one of the protruding part and the flange part may be formed to form the gap S1. In this regard, a specific description will be given with reference to FIG. 4 as an example of a case in which only the protruding part is formed. The same configurations as those of the shunt sensor 1 shown in FIG. 1 and FIG. 2 and the shunt sensor 1A shown in FIG. 3 are denoted by the same reference signs, and their detailed description will be omitted.

A shunt sensor 1B shown in FIG. 4 is composed of a shunt resistor 2B, a substrate 3B, and fixing terminals 4B. The differences between the shunt resistor 2B shown in FIG. 4 and the shunt resistor 2 shown in FIG. 1 and FIG. 2 are that a fixing terminal recessed hole 21aB into which the fixing terminal 4B is inserted is formed on the upper surface of the base member 21 in addition to the recessed hole 21a, and also that the measurement terminal 22B is formed only of a rod-like shaft part 22a.

On the other hand, the difference between the substrate 3B shown in FIG. 4 and the substrate 3 shown in FIG. 1 and FIG. 2 is that a fixing terminal through hole 30aB into which the fixing terminal 4B can be inserted is newly provided, and other aspects are the same. The fixing terminal through hole 30aB is provided in each side end face side of the substrate main body 30 and provided in a vertically and circularly penetrating manner.

Further, the difference between the fixing terminal 4B shown in FIG. 4 and the fixing terminal 4A shown in FIG. 3 is that the fixing terminal 4A is formed only of the rod-like shaft part 4aA.

Thus, the shaft part 22a of the measurement terminal 22B thus formed is inserted into the recessed hole 21a and the side circumferential surface of the shaft part 22a is welded 22cB by, for example, resistance welding, whereby the measurement terminal 22B is erected and fixed on the base member 21. Further, the shaft part 4aA of the fixing terminal 4B is inserted into the fixing terminal recessed hole 21aB and the side circumferential surface of the shaft part 4aA is welded 4cB by, for example, resistance welding, whereby the fixing terminal 4B is erected and fixed on the base member 21.

When, in this state, the shaft part 4aA of the fixing terminal 4B is inserted into the fixing terminal through hole 30aB and the shaft part 22a of the measurement terminal 22 is inserted into the through hole 30a, the lower surface of the substrate main body 30 is placed on the protruding part 21b of the base member 21. Then, in this state, as shown in FIG. 4, when the side circumferential surface of the shaft part 22a located on the upper surface side of the substrate main body 30 is welded 32B by, for example, resistance welding, and further, the side circumferential surface of the shaft part 4aA located on the upper surface side of the substrate main body 30 is welded 4dB by, for example, resistance welding, the substrate 3B is arranged and fixed at a position opposed to the base member 21.

Thus, in this way as well, as shown in FIG. 4, a gap S1 is formed between the base member 21 and the substrate 3B, and the heat generated in the resistor 20 and its periphery is dissipated by the gap S1.

Thus, in the present embodiment as well, the heat dissipation measures can be improved.

Further, all parts are fixed only by welding, instead of being screw-fixed as in the conventional case, the number of parts can therefore be reduced.

Further, since a plurality of fixing terminals 4B (three in the illustration) are used to arrange and fix the substrate 3B at the position opposed to the base member 21, the substrate 3B is more firmly arranged and fixed.

One of the plurality of fixing terminals 4B (three in the illustration) is connected to a ground pattern (not shown) formed on the substrate main body 30. As a result, anti-noise measures can be taken and the current value of the current path through which a large current flows from the battery for high-voltage applications to the motor circuit can be measured with high accuracy. Further, in order to reduce the possibility of causing a measurement error, only one of the plurality of fixing terminals 4B (three in the illustration) is connected to the ground pattern (not shown) formed on the substrate main body 30.

Meanwhile, in the present embodiments, the thick plate-like rectangular shape is exemplified as the shape of the protruding part 21b, 21bA, but without being limited thereto, the shape may be circular or may be any shape as long as the substrate main body 30 can be placed thereon. Further, when the protruding part 21b, 21bA is formed on the upper surface of the base member 21, the protruding part 21b, 21bA does not necessarily have to be formed over the entire width direction of the base member 21, but may be formed only on a central part in the width direction or may be formed at any position.

### Industrial Applicability

It is useful that the shunt sensors 1, 1A, 1B exemplified in the present embodiments is particularly used in measuring a current value of a current path through which a large current flows from a battery for high-voltage applications to a motor circuit that are used in, for example, electric vehicles (EVs), hybrid vehicles (HVs), and plug-in hybrid vehicles (PHVs).

### Reference Sings List

1, 1A, 1B Shunt sensor
2, 2A, 2B Shunt resistor
3, 3A, 3B Substrate
4A, 4B Fixing terminal
20 Resistor
21 Base member
21b Protruding part
22, 22B Measurement terminal
22a Shaft part
22b Flange part
32, 32B welding
S1 Gap

## Claims

1. A shunt sensor (1) including:
a resistor (20);
a pair of base members (21) sandwiching the resistor (20) and integrally formed with the resistor (20);
a measurement terminal (22) fixed on each of the base members (21); and
a substrate (3) into which the measurement terminals (22) are inserted, the substrate (3) arranged and fixed at a position opposed to the base members (21),
wherein the measurement terminals (22) each include:
a shaft part (22a); and
a flange part (22b) protruding outward in a circumferential direction of the shaft part (22a) so as to protrude from the corresponding base member (21) when the measurement terminals (22) are fixed on the base members (21),
**characterized in that**:
the pair of base members (21) are each provided with a protruding part (21b) integrally formed on a surface opposed to the substrate (3),
the flange part (22b) and the protruding part (21b) are formed with the same thickness,
only the shaft part (22a) of the measurement terminal (22) is inserted into the substrate (3), the lower surface of the substrate (3) is placed on the flange part (22b), and also placed on the protruding part (21b), and in this state, the substrate (3) is arranged and fixed at the position opposed to the base member (21) by welding a side circumferential surface of the shaft part (22a) of the measurement terminal (22) placed on the upper surface side of the substrate (3).

2. A shunt sensor (1A) including:
a resistor (20);
a pair of base members (21) sandwiching the resistor (20) and integrally formed with the resistor (20);
a measurement terminal (22) fixed on each of the base members (21);
fixing terminals (4A), and
a substrate (3A) into which the measurement terminals (22) and the fixing terminals (4A) are inserted, the substrate (3A) arranged and fixed at a position opposed to the base members (21),
**characterized in that**:
the measurement terminals (22) each include:
a first shaft part (22a); and
a first flange part (22b) protruding outward in a circumferential direction of the first shaft part (22a) so as to protrude from the corresponding base member (21) when the measurement terminal (22) is fixed on the base member (21), and
the fixing terminals (4A) each have a second shaft part (4aA) and
a second flange part (4bA) protruding outward in a circumferential direction of the second shaft part (4aA),
the pair of base members (21) are each provided with a protruding part (21bA) integrally formed on a surface opposed to the substrate (3A),
the thickness of the first flange part (22b) is formed so as to be the same as the sum of the thickness of the protruding part (21bA) and the thickness of the second flange part (4bA),
the first shaft part (22a) of the measurement terminal (22) and the second shaft part (4aA) of the fixing terminals (4A) are inserted into the substrate (3A), the second flange part (4bA) is placed on the protruding part (21bA), and further, the lower surface of the substrate (3A) is placed on the first flange part (22b) and also placed on the second flange part (4bA), and in this state, the substrate (3A) is arranged and fixed at the position opposed to the base member (21) by welding a side circumferential surface of the first shaft part (22a) of the measurement terminal (22) and a side circumferential surface of the second shaft part (4aA) of the fixing terminals (4A), which are placed on the upper surface side of the substrate (3A).

3. A shunt sensor (1B) including:
a resistor (20);
a pair of base members (21) sandwiching the resistor (20) and integrally formed with the resistor (20);
a measurement terminal (22B) fixed on each of the base members (21);
a fixing terminal (4B), and
a substrate (3B) into which the measurement terminals (22B) are inserted,
the substrate (3B) arranged and fixed at a position opposed to the base members (21),
**characterized in that**:
the measurement terminal (22B) has only a first shaft part (22a),
the fixing terminal (4B) has only a second shaft part (4aA),
the pair of base members (21) are each provided with a protruding part (21b) integrally formed on a surface opposed to the substrate (3b),
the first shaft part (22a) of the measurement terminal (22B) and the second shaft part (4aA) of the fixing terminal (4B) are inserted into the substrate (3B), and the lower surface of the substrate (3B) is placed on the protruding part (21b), and in this state, the substrate (3B) is arranged and fixed at the position opposed to the base member (21) by welding a side circumferential surface of the first shaft part (22a) of the measurement terminal (22B) and a side circumferential surface of the second shaft part (4aA) of the fixing terminal (4B) placed on the upper surface side of the substrate (3B).

4. The shunt sensor according to claim 2, wherein one of the fixing terminals (4A) fixed to the substrate (3A) is connected to a ground pattern formed on the substrate (3A).

## Patentansprüche

1. Shunt-Sensor (1), einschließend:
einen Widerstand (20);
ein Paar von Basiselementen (21), die den Widerstand (20) zwischen sich aufnehmen und einstückig mit dem Widerstand (20) gebildet sind;
einen Messanschluss (22), der an jedem der Basiselementen (21) befestigt ist; und
ein Substrat (3), in das die Messanschlüsse (22) eingesetzt sind, wobei das Substrat (3) an einer den Basiselementen (21) gegenüberliegenden Position angeordnet und befestigt ist,
wobei die Messanschlüsse (22) jeweils Folgendes einschließen:
einen Schaftabschnitt (22a); und
einen Flanschabschnitt (22b), der sich in einer Umfangsrichtung des Schaftabschnitts (22a) nach außen erstreckt, sodass er aus dem entsprechenden Basiselement (21) herausragt, wenn die Messanschlüsse (22) an den Basiselementen (21) befestigt sind, **dadurch gekennzeichnet, dass**:
das Paar von Basiselementen (21) jeweils mit einem vorstehenden Abschnitt (21b) bereitgestellt ist, der einstückig an einer dem Substrat (3) gegenüberliegenden Oberfläche gebildet ist,
der Flanschabschnitt (22b) und der vorstehende Abschnitt (21b) mit derselben Dicke gebildet sind, nur der Schaftabschnitt (22a) des Messanschlusses (22) in das Substrat (3) eingesetzt ist, wobei die Unterseite des Substrats (3) auf dem Flanschabschnitt (22b) und außerdem auf dem vorstehenden Abschnitt (21b) aufliegt, und in diesem Zustand das Substrat (3) an der dem Basiselement (21) gegenüberliegenden Position angeordnet und befestigt ist, indem eine seitliche Umfangsfläche des Schaftabschnitts (22a) des Messanschlusses (22), der auf der Oberflächenseite des Substrats (3) angeordnet ist, verschweißt wird.

2. Shunt-Sensor (1A), aufweisend:
einen Widerstand (20);
ein Paar von Basiselementen (21), die den Widerstand (20) zwischen sich aufnehmen und einstückig mit dem Widerstand (20) gebildet sind;
einen Messanschluss (22), der an jedem der Basiselemente (21) befestigt ist; Befestigungsanschlüsse (4A), und
ein Substrat (3A), in das die Messanschlüsse (22) und die Befestigungsanschlüsse (4A) eingesetzt sind, wobei das Substrat (3A) an einer den Basiselementen (21) gegenüberliegenden Position angeordnet und befestigt ist,
**dadurch gekennzeichnet, dass**:
die Messanschlüsse (22) jeweils Folgendes einschließen:
einen ersten Schaftabschnitt (22a); und
einen ersten Flanschabschnitt (22b), der sich in einer Umfangsrichtung des ersten Schaftabschnitts (22a) nach außen erstreckt, sodass er aus dem entsprechenden Basismaterial (21) herausragt, wenn der Messanschluss (22) an dem Basismaterial (21) befestigt ist, und
die Befestigungsanschlüsse (4A) jeweils einen zweiten Schaftabschnitt (4aA) aufweisen und
einen zweiten Flanschabschnitt (4bA), der sich in einer Umfangsrichtung des zweiten Schaftabschnitts (4aA) nach außen erstreckt,
das Paar von Basiselementen (21) jeweils mit einem vorstehenden Abschnitt (21bA) bereitgestellt ist, der einstückig an einer dem Substrat (3A) gegenüberliegenden Oberfläche gebildet ist,
die Dicke des ersten Flanschabschnitts (22b) so gebildet ist, dass sie gleich der Summe aus der Dicke des vorstehenden Abschnitts (21bA) und der Dicke des zweiten Flanschabschnitts (4bA) ist,
der erste Schaftabschnitt (22a) des Messanschlusses (22) und der zweite Schaftabschnitt (4aA) der Befestigungsanschlüsse (4A) in das Substrat (3A) eingesetzt sind, der zweite Flanschabschnitt (4bA) auf dem vorstehenden Abschnitt (21bA) aufliegt und ferner die Unterseite des Substrats (3A) auf dem ersten Flanschabschnitt (22b) und außerdem auf dem zweiten Flanschabschnitt (4bA) aufliegt, und in diesem Zustand das Substrat (3A) an der dem Basiselement (21) gegenüberliegenden Position angeordnet und befestigt ist, indem eine seitliche Umfangsfläche des ersten Schaftabschnitts (22a) des Messanschlusses (22) und eine seitliche Umfangsfläche des zweiten Schaftabschnitts (4aA) der Befestigungsanschlüsse (4A), die auf der Oberflächenseite des Substrats (3A) angeordnet sind, verschweißt werden.

3. Shunt-Sensor (1B), aufweisend:
einen Widerstand (20);
ein Paar von Basiselementen (21), die den Widerstand (20) zwischen sich aufnehmen und einstückig mit dem Widerstand (20) gebildet sind;
einen Messanschluss (22B), der an jedem der Basiselementen (21) befestigt ist;
einen Befestigungsanschluss (4B), und
ein Substrat (3B), in das die Messanschlüsse (22B) eingesetzt sind, wobei das Substrat (3B) an einer den Basiselementen (21) gegenüberliegenden Position angeordnet und befestigt ist, **dadurch gekennzeichnet, dass**:
der Messanschluss (22B) nur einen ersten Schaftabschnitt (22a) aufweist,
der Befestigungsanschluss (4B) nur einen zweiten Schaftabschnitt (4aA) aufweist,
das Paar von Basiselementen (21) jeweils mit einem vorstehenden Abschnitt (21b) bereitgestellt ist, der einstückig an einer dem Substrat (3b) gegenüberliegenden Oberfläche gebildet ist,
der erste Schaftabschnitt (22a) des Messanschlusses (22B) und der zweite Schaftabschnitt (4aA) des Befestigungsanschlusses (4B) in das Substrat (3B) eingesetzt sind, und die Unterseite des Substrats (3B) auf dem vorstehenden Abschnitt (21b) aufliegt und in diesem Zustand, das Substrat (3B) an der dem Basiselement (21) gegenüberliegenden Position angeordnet und befestigt ist, indem eine seitliche Umfangsfläche des ersten Schaftabschnitts (22a) des Messanschlusses (22B) und eine seitliche Umfangsfläche des zweiten Schaftabschnitts (4aA) des Befestigungsanschlusses (4B), die auf der Oberflächenseite des Substrats (3B) angeordnet sind, verschweißt werden.

4. Shunt-Sensor nach Anspruch 2, wobei einer der an dem Substrat (3A) befestigten Befestigungsanschlüsse (4A) mit einer auf dem Substrat (3A) gebildeten Masseleiterbahn geschaltet ist.

## Revendications

1. Capteur de dérivation (1) incluant :
une résistance (20) ;
une paire d'éléments de base (21) qui prennent en sandwich la résistance (20) et qui sont formés d'un seul tenant avec la résistance (20) ;
une borne de mesure (22) fixée sur chacun des éléments de base (21) ; et
un substrat (3) dans lequel les bornes de mesure (22) sont insérées, le substrat (3) étant disposé et fixé à une position opposée aux éléments de base (21),
dans lequel les bornes de mesure (22) incluent chacune :
une partie d'arbre (22a) ; et
une partie de bride (22b) faisant saillie vers l'extérieur dans une direction circonférentielle de la partie d'arbre (22a) de façon à faire saillie par rapport à l'élément de base (21) correspondant lorsque les bornes de mesure (22) sont fixées sur les éléments de base (21),
**caractérisé en ce que** :
chacun des éléments de base (21) de la paire d'éléments de base (21) est pourvu d'une partie saillante (21b) formée d'un seul tenant sur une surface opposée au substrat (3),
la partie de bride (22b) et la partie saillante (21b) sont formées avec la même épaisseur,
seule la partie d'arbre (22a) de la borne de mesure (22) est insérée dans le substrat (3), la surface inférieure du substrat (3) est placée sur la partie de bride (22b) et également placée sur la partie saillante (21b),
et, dans cet état, le substrat (3) est disposé et fixé à la position opposée à l'élément de base (21) par soudage d'une surface périphérique latérale de la partie d'arbre (22a) de la borne de mesure (22) placée sur le côté de la surface supérieure du substrat (3).

2. Capteur de dérivation (1A) incluant :
une résistance (20) ;
une paire d'éléments de base (21) qui prennent en sandwich la résistance (20) et qui sont formés d'un seul tenant avec la résistance (20) ;
une borne de mesure (22) fixée sur chacun des éléments de base (21) ;
des bornes de fixation (4A), et
un substrat (3A) dans lequel les bornes de mesure (22) et les bornes de fixation (4A) sont insérées, le substrat (3A) étant disposé et fixé à une position opposée aux éléments de base (21),
**caractérisé en ce que** :
les bornes de mesure (22) incluent chacune :
une première partie d'arbre (22a) ; et
une première partie de bride (22b) faisant saillie vers l'extérieur dans une direction circonférentielle de la première partie d'arbre (22a) de façon à faire saillie par rapport à l'élément de base (21) correspondant lorsque la borne de mesure (22) est fixée sur l'élément de base (21), et
les bornes de fixation (4A) présentent chacune une deuxième partie d'arbre (4aA) et
une deuxième partie de bride (4bA) faisant saillie vers l'extérieur dans une direction circonférentielle de la deuxième partie d'arbre (4aA),
chacun des éléments de base (21) de la paire d'éléments de base (21) est pourvu d'une partie saillante (21bA) formée d'un seul tenant sur une surface opposée au substrat (3A),
l'épaisseur de la première partie de bride (22b) est formée de sorte à être identique à la somme de l'épaisseur de la partie saillante (21bA) et de l'épaisseur de la deuxième partie de bride (4bA),
la première partie d'arbre (22a) de la borne de mesure (22) et la deuxième partie d'arbre (4aA) des bornes de fixation (4A) sont insérées dans le substrat (3A), la deuxième partie de bride (4bA) est placée sur la partie saillante (21bA), et, en outre, la surface inférieure du substrat (3A) est placée sur la première partie de bride (22b) et également placée sur la deuxième partie de bride (4bA),
et, dans cet état, le substrat (3A) est disposé et fixé à la position opposée à l'élément de base (21) par soudage d'une surface périphérique latérale de la première partie d'arbre (22a) de la borne de mesure (22) et d'une surface périphérique latérale de la deuxième partie d'arbre (4aA) des bornes de fixation (4A), qui sont placées sur le côté de la surface supérieure du substrat (3A).

3. Capteur de dérivation (1B) incluant :
une résistance (20) ;
une paire d'éléments de base (21) qui prennent en sandwich la résistance (20) et qui sont formés d'un seul tenant avec la résistance (20) ;
une borne de mesure (22B) fixée sur chacun des éléments de base (21) ;
une borne de fixation (4B), et
un substrat (3B) dans lequel les bornes de mesure (22B) sont insérées,
le substrat (3B) étant disposé et fixé à une position opposée aux éléments de base (21),
**caractérisé en ce que** :
la borne de mesure (22B) ne présente qu'une première partie d'arbre (22a),
la borne de fixation (4B) ne présente qu'une deuxième partie d'arbre (4aA),
chacun des éléments de base (21) de la paire d'éléments de base (21) est pourvu d'une partie saillante (21b) formée d'un seul tenant sur une surface opposée au substrat (3b),
la première partie d'arbre (22a) de la borne de mesure (22B) et la deuxième partie d'arbre (4aA) de la borne de fixation (4B) sont insérées dans le substrat (3B), et la surface inférieure du substrat (3B) est placée sur la partie saillante (21b), et, dans cet état,
le substrat (3B) est disposé et fixé à la position opposée à l'élément de base (21) par soudage d'une surface périphérique latérale de la première partie d'arbre (22a) de la borne de mesure (22B) et d'une surface périphérique latérale de la deuxième partie d'arbre (4aA) de la borne de fixation (4B), qui sont placées sur le côté de la surface supérieure du substrat (3B).

4. Capteur de dérivation selon la revendication 2, dans lequel l'une des bornes de fixation (4A) fixées au substrat (3A) est reliée à un motif de masse formé sur le substrat (3A).
